# EUROPÄISCHE PATENTSCHRIFT

(11) **EP 1 115 950 B1**
(45) Veröffentlichungstag und Bekanntmachung des Hinweises auf die Patenterteilung: **05.11.2003**
(21) Anmeldenummer: 99946027.2
(22) Anmeldetag: 26.08.1999
(51) Int. Cl.: D21H 23/56, D21H 23/78, D21H 25/12

(54) **RAKELSTANGE FÜR EINE BESCHICHTUNGSVORRICHTUNG**
DOCTOR ROD FOR A COATING DEVICE
RACLE EN FORME DE TIGE DESTINEE A UN DISPOSITIF DE RECOUVREMENT

(30) Priorität: 08.09.1998 DE 19840951
(43) Veröffentlichungstag der Anmeldung: 18.07.2001
(73) Patentinhaber: Voith Paper Patent GmbH, 89522 Heidenheim (DE)
(72) Erfinder: RÜCKERT, Hans, D-40882 Ratingen (DE); SCHOOF, Ulrich, D-40591 Düsseldorf (DE)
(74) Vertreter: Jantsch, Sigrid
(86) Internationale Anmeldenummer: EP9906256
(87) Internationale Veröffentlichungsnummer: WO00014332

(56) Entgegenhaltungen:
- EP-A- 0 207 921
- EP-A- 0 454 643
- EP-A- 0 456 847
- WO-A-99/22041
- DE-A- 3 937 749
- FR-A- 2 770 156
- DATABASE WPI Section Ch, Week 199130 Derwent Publications Ltd., London, GB; Class E36, AN 1991-217774 XP002122151 & JP 03 137938 A (SUMITOMO METAL IND LTD), 12. Juni 1991 (1991-06-12)

## Beschreibung

### Technisches Gebiet

Die Erfindung betrifft eine Rakelstange für eine Beschichtungsvorrichtung, insbesondere für eine Vorrichtung zum Beschichten von Papier- oder Kartonbahnen mit Pigmentstreichfarbe, die einen zylinderförmigen Grundkörper aus Stahl aufweist, auf dessen Mantelfläche eine Hartstoffschicht aus Chrom oder Keramik aufgebracht ist.

### Stand der Technik

In Auftrag- und Dosiersystemen von Vorrichtungen zum Beschichten von Papier- oder Kartonbahnen werden Rakelstangen bekannterweise als Dosierelemente eingesetzt. Sie dienen dazu, auf einer Walze oder direkt auf der Papier- oder Kartonbahn durch Abrakeln einen exakt dosierten Film an Beschichtungsmaterial (Leim, Stärke, Pigmentstreichfarbe etc.) zu erzeugen, das von einem vorgeschalteten Auftragwerk im Überschuß aufgetragen wurde.

Beim Beschichten von Papier- oder Kartonbahnen werden Rakelstangen mit einem Durchmesser zwischen 8 mm und 50 mm eingesetzt, die sich über die gesamte Arbeitsbreite erstrecken, deren Länge somit bis zu 10 m beträgt. Um die Rakelstangen über ihre gesamte Länge gegen Durchbiegung abzustützen, sind sie üblicherweise in einem Bett aus einem elastomeren Material gelagert, das zur Walze/Bahn hin eine Öffnung aufweist, aus der die Rakelstange umfänglich herausragt. Eine derart gelagerte Rakelstange ist beispielsweise in der DE 30 22 955-C beschrieben.

Die Rakelstangen weisen entweder eine glatte Mantelfläche auf (EP 0 454 643-B1) oder sie sind auf ihrer Mantelfläche mit umlaufenden Rillen profiliert (DE 37 35 889-A1). Bei Rakelstangen mit profilierter Mantelfläche läßt sich die Strichdicke des dosierten Films auf der Walze/Bahn über die freie Querschnittsfläche der Rillen beeinflussen. Sie werden bevorzugt eingesetzt, um in einen indirekten Auftragsverfahren auf einer Walze einen dosierten Film an Beschichtungsmaterial zu erzeugen, der anschließend in einem Preßspalt von der Walze an die Bahn übergeben wird (EP 0 453 427-A2).

Da die Rakelstangen, insbesondere beim Beschichten von abrasiv wirkenden X Pigmentstreichfarben, erheblich verschleißend beansprucht werden, ist es bekannt auf deren Oberfläche einen Überzug aufzubringen, welcher mit einem thermischen spritzverfahren realisert wird. Dies ist offenbard in der WO-A-9922041 bzw.DET-T2-68901287. Es ist außerdem bekannt, Rakelstangen aus einem zylinderförmigen Grundkörper aus Stahl aufzubauen, der mit einer Hartstoffschicht aus Chrom (EP 0 454 643-B1 ) oder Keramik (DE 39 37 749-A1 ) beschichtet ist. Auch die mit einer Hartstoffschicht aus Chrom oder Keramik versehenen Rakelstangen verschleißen im Betrieb, so dass sie in regelmäßigen Zeitabständen ausgetauscht werden müssen.

### Darstellung der Erfindung

Der Erfindung liegt die Aufgabe zugrunde, eine Rakelstange für eine Beschichtungsvorrichtung zu schaffen, die eine gegenüber den bekannten Rakelstangen vergrößerte Standzeit aufweist.

Diese Aufgabe wird mit den Merkmalen des Patentanspruchs 1 gelöst.

Es hat sich gezeigt, dass beim Auftragen der Hartstoffschicht auf den Grundkörper aus Stahl in deren Oberfläche Mikrorisse und -krater entstehen, von denen die Abriebfestigkeit und Korrosionsbeständigkeit der Rakelstangen negativ beeinflußt wird. Zusätzlich wird durch die erfindungsgemäße Veredelung die Härte der Rakelstangen erhöht.

Als weiterer Vorteil tritt hinzu, dass die Strichqualität des von der Rakelstange dosierten Films verbessert wird, da die Oberfläche der Rakelstange eine geringere Rauhigkeit aufweist. Das Strichbild wird somit gleichmäßiger.

Die Unteransprüche enthalten bevorzugte, da zum Beschichten von Papier- oder Kartonbahnen besonders vorteilhafte Ausgestaltungen einer erfindungsgemäßen Rakelstange.

### Kurze Beschreibung der Zeichnung

Die Zeichnung dient zur Erläuterung der Erfindung anhand eines vereinfacht dargestellten Ausführungsbeispiels.
- Figur 1: zeigt eine Rakelstange nach der Erfindung.
- Figur 2: zeigt als Prinzipskizze eine Beschichtungsvorrichtung, bei der die Rakelstange bevorzugt eingesetzt wird.

### Wege zur Ausführung der Erfindung

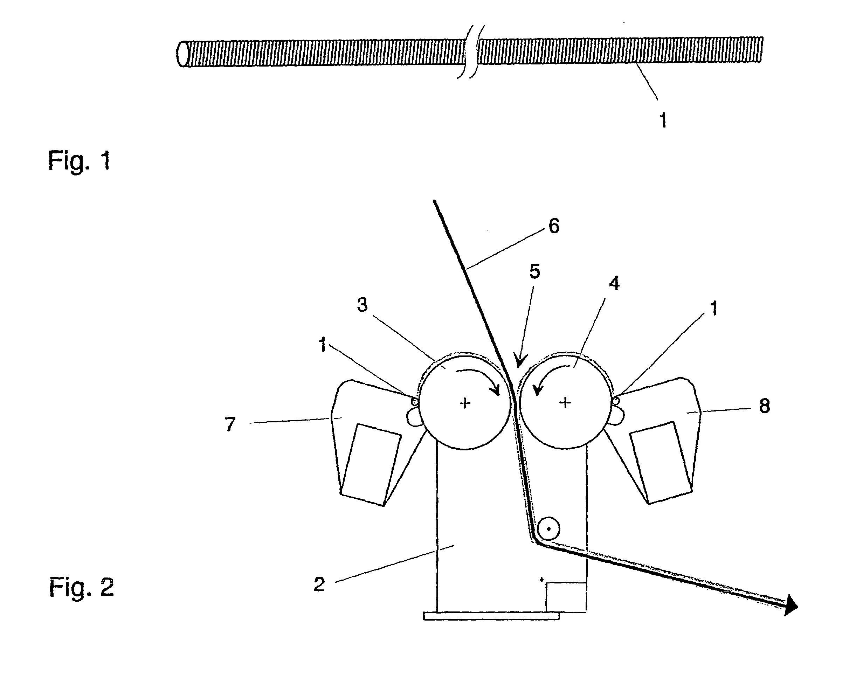

Die in Figur 1 gezeigte Rakelstange 1 enthält einen zylinderförmigen Grundkörper aus einem rost- und säurebeständigen Stahl, auf dessen Mantelfläche eine Hartstoffschicht aus Chrom oder Keramik aufgebracht ist. Bevorzugt wird als Hartstoffschicht eine Chromschicht aufgetragen, die eine Dicke von 20 µm bis 60 µm, vorzugsweise 40 µm bis 50 µm, aufweist. Ihre axiale Länge ist der Arbeitsbreite der Beschichtungsvorrichtung angepaßt, die bis zu 10 m betragen kann. Der Außendurchmesser der Rakelstange 1 beträgt 8 mm bis 50 mm, im Beispiel ca. 12 mm. Je nach Anwendungsfall ist die Mantelfläche der Rakelstange 1 glatt oder enthält - wie in Figur 1 dargestellt - umfänglich verlaufende Rillen. Die umfänglich verlaufenden Rillen sind durch sogenanntes Rollwalzen in die Hartstoffschicht - hier die Chromschicht - eingearbeitet. Sie verlaufen schraubenlinienförmig unter einem bestimmten Steigungswinkel. Die Rillen sind so gestaltet, dass sie eine in Achsrichtung der Rakelstange gemessene Breite von 0,1 mm bis 0,3 mm und eine Tiefe von 0,07 mm bis 0,13 mm aufweisen. Die bei einem zentralen Längsschnitt durch die Rakelstange 1 sich ergebene offene Querschnittsfläche der Rillen beträgt zwischen 25 mm² und 150 mm² pro Meter Rakelstangenlänge.

Nach dem Aufbringen der Hartstoffschicht und bei gerillten Rakelstangen nach dem Einarbeiten der Rillen wird die Oberfläche der Hartstoffschicht mit einem lonenimplantationsverfahren veredelt. Die Oberfläche der Hartstoffschicht wird mit energiereichen Ionen im Plasmazustand beschossen, die mit dem Hartstoff reagieren und eine Verbindung herstellen. Die physikalischen Parameter des lonenimplantationsverfahrens sind so eingestellt, dass die Risse und Krater in der Oberfläche der Hartstoffschicht von der entstehenden Verbindung abgedeckt werden, ohne dass eine störende, da die Rillen abdeckende Schicht erzeugt wird. Bevorzugt wird die Hartstoffoberfläche mit einer lonenmischung behandelt, die Stickstoff- und/oder Kohlenstoffionen, jedoch keine Mono-Metallionen, enthält. Als geeignetes ionisiertes Gas im Plasmazustand hat sich eine Mischung aus NH3 oder N₂ und CO₂ mit einem Inertgas (Helium oder Argon) gezeigt. Es bildet sich eine die Risse und Krater in der Oberfläche abdeckende Verbindung, die aus Chromnitrid, Chromkarbid und/oder Chromkarbonitrid besteht. Zusätzlich wird die Härte der Hartstoffschicht gesteigert. Beim Veredeln einer Chromschicht wird eine Härte nach der Plasmabehandlung von mehr als 1200 HV, vorzugsweise von 1400 HV bis 1600 HV, eingestellt. Eine derart veredelte Rakelstange hat eine auf das Mehrfache gesteigerte Standzeit und trägt zudem das Beschichtungsmaterial gleichmäßiger auf.

Bevorzugt wird die nach der Erfindung veredelte Rakelstange 1 in einer Beschichtungsvorrichtung zum Beschichten von Papier- oder Kartonbahnen mit Pigmentstreichfarbe eingesetzt, deren Prinzip in Figur 2 dargestellt ist. Die Beschichtungsvorrichtung enthält zwei achsparallel nebeneinander in einem Gestell 2 drehbar gelagerten Walzen 3, 4, von denen eine Walze 3 ortsfest, die andere Walze 4 umfänglich gegen die ortsfeste Walze 3 anpreßbar gelagert ist, um einen Preßspalt 5 zu bilden, durch den die Papier- oder Kartonbahn 6 von oben nach unten verlaufend geführt wird. Beide Walzen 3, 4 sind auf ihrer Mantelfläche gummiert.

Außerhalb des Bereichs des Preßspalts 5, bevorzugt jeweils zu diesem in etwa diametral entgegengesetzt, ist an jeder Walze 3, 4 ein Auftrag- und Dosiersystem 7, 8 angeordnet, das an die jeweilige Walze 3, 4 anschwenkbar ist. Von jedem Auftrag- und Dosiersystem 7, 8 wird Beschichtungsmaterial (hier Pigmentstreichfarbe) auf die Mantelfläche der zugehörigen Walze 3, 4 zunächst im Überschuß aufgetragen und unmittelbar anschließend bis auf die gewünschte Filmdicke von der Rakelstange 1 wieder abgerakelt. Die Rakelstange 1 ist dabei auf bekannte Weise drehbar in einem zur Walze 3, 4 hin offenen Rakelbett gelagert, das in einem Halter angeordnet sich über die gesamte Arbeitsbreite der Vorrichtung erstreckt und so die Rakelstange 1 abstützt. An der rückwärtigen Seite des Rakelbetts befindet sich ein Druckschlauch, der zur Anpressung der Rakelstange 1 an die Walze 3, 4 mit Druckluft beaufschlagt werden kann.

Ebenso kann die Rakelstange 1 nach der Erfindung vorteilhaft bei den bekannten Vorrichtungen zum direkten Beschichten einer Papier- oder Kartonbahn eingesetzt werden. Bei diesen Vorrichtungen wird das Beschichtungsmaterial direkt auf die Papier- oder Kartonbahn aufgetragen und dosiert. Sie weisen eine Gegenwalze auf, um die die Papier- oder Kartonbahn geführt ist. Im von der Bahn umschlungenen Bereich der Gegenwalze ist ein Auftragwerk, beispielsweise ein Walzen- oder Düsenauftragwerk, angeordnet, das Beschichtungsmaterial im Überschuß auf die Bahn aufträgt. In Bahnlaufrichtung hinter dem Auftragwerk folgt ein Dosiersystem mit einem Dosierelement, das von der Bahn das überschüssige Beschichtungsmaterial bis auf das gewünschte Strichgewicht abrakelt. Als Dosierelemente werden bevorzugt Rakelstangen mit glatter Mantelfläche eingesetzt, die auf die vorstehend beschriebene Weise veredelt sind.

## Patentansprüche

1. Rakelstange für eine Beschichtungsvorrichtung
mit einem zylinderförmigen Grundkörper aus Stahl, auf dessen Mantelfläche eine Hartstoffschicht aus Chrom oder Keramik aufgebracht ist, **dadurch gekennzeichnet, dass** die Risse und Krater in der Oberfläche der Hartstoffschicht von einer Verbindung geschlossen sind, die in einem lonenimplantationsverfahren durch eine Reaktion des Hartstoffs mit den in einem Plasma applizierten Ionen hergestellt wurde.

2. Rakelstange nach Anspruch 1, **dadurch gekennzeichnet, dass** die Hartstoffoberfläche bei der Herstellung der Rakelstange (1) mit einer lonenmischung behandelt wurde, die Stickstoff- und/oder Kohlenstoffionen, jedoch keine Mono-Metallionen enthält.

3. Rakelstange nach Anspruch 1 oder 2, **dadurch gekennzeichnet, dass** die abdeckende Verbindung aus Chromnitrid, Chromkarbid und/oder Chromkarbonitrid besteht.

4. Rakelstange nach einem der Ansprüche 1 bis 3, **dadurch gekennzeichnet, dass** als Hartstoffschicht eine Chromschicht von 20 µm bis 60 µm, vorzugsweise 40 µm bis 50 µm, Dicke aufgebracht ist.

5. Rakelstange nach einem der Ansprüche 3 bis 5, **dadurch gekennzeichnet, dass** die Chromschicht nach der Plasmabehandlung eine Härte von mehr als 1200 HV, vorzugsweise von 1400 HV bis 1600 HV, aufweist.

6. Rakelstange nach einem der Ansprüche 1 bis 5, **dadurch gekennzeichnet, dass** die Mantelfläche der Rakelstange (1) umfänglich verlaufende Rillen aufweist.

7. Rakelstange nach Anspruch 6, **dadurch gekennzeichnet, dass** die sich bei einem zentralen Längsschnitt durch die Rakelstange (1) ergebene offene Querschnittsfläche der Rillen zwischen 25 mm² und 150 mm² pro Meter Rakelstangenlänge beträgt.

8. Rakelstange nach Anspruch 6 oder 7, **dadurch gekennzeichnet, dass** die umfänglichen Rillen eine in Achsrichtung der Rakelstange (1) gemessene Breite von 0,1 mm bis 0,3 mm und eine Tiefe von 0,07 mm bis 0,13 mm aufweisen.

9. Vorrichtung zum Beschichten einer Materialbahn (8), insbesondere eine Papier- oder Kartonbahn mit Pigmentfarbe, mit zwei achsparallel nebeneinander in einem Gestell gelagerten Walzen (3, 4), von denen eine Walze (3) umfänglich gegen die andere Walze (4) anpreßbar gelagert ist, und
mit zumindest einem Auftrag- und Dosiersystem (7, 8) für eine Walze (3, 4), der außerhalb des Bereichs des zwischen den Walzen (3, 4) gebildeten Preßspalts (5) gegen die Mantelfläche einer Walze (3, 4) anstellbar ist, **dadurch gekennzeichnet, dass** das Dosiersystem (7, 8) als Dosierelement eine Rakelstange (1) gemäß einem der Ansprüche 1 bis 8 enthält.

10. Vorrichtung zum Beschichten einer Materialbahn, insbesondere einer Papier- oder Kartonbahn, mit einer Gegenwalze, um die die Materialbahn geführt ist, mit einem Auftragwerk in dem von der Materialbahn umschlungenen Bereich der Gegenwalze und mit einem in Bahnlaufrichtung folgenden Dosiersystem, **dadurch gekennzeichnet, dass** das Dosiersystem als Dosierelement eine Rakelstange gemäß einem der Ansprüche 1 bis 8 enthält.

## Claims

1. Doctor rod for a coating apparatus, comprising a cylindrical base body of steel, to the circumferential surface of which a hard material layer of chromium or ceramic is applied, **characterized in that** the cracks and craters in the surface of the hard material layer are closed by a compound which has been produced in an ion implantation process by means of a reaction between the hard material and the ions applied in a plasma.

2. Doctor rod according to Claim 1, **characterized in that**, during the production of the doctor rod (1), the hard material surface has been treated with an ion mixture which contains nitrogen and/or carbon ions but no mono-metal ions.

3. Doctor rod according to Claim 1 or 2, **characterized in that** the covering compound consists of chromium nitride, chromium carbide and/or chromium carbon nitride.

4. Doctor rod according to one of Claims 1 to 3, **characterized in that** the hard material layer applied is a chromium layer with a thickness of 20 µm to 60 µm, preferably 40 µm to 50 µm.

5. Doctor rod according to one of Claims 3 to 5, **characterized in that**, following the plasma treatment, the chromium layer has a hardness of more than 1200 HV, preferably of 1400 HV to 1600 HV.

6. Doctor rod according to one of Claims 1 to 5, **characterized in that** the circumferential surface of the doctor rod (1) has grooves running circumferentially.

7. Doctor rod according to Claim 6, **characterized in that** the open cross-sectional area of the grooves, resulting from a central longitudinal section through the doctor rod (1), is between 25 mm² and 150 mm² per metre of doctor rod length.

8. Doctor rod according to Claim 6 or 7, **characterized in that** the circumferential grooves have a width measured in the axial direction of the doctor rod (1) of 0.1 mm to 0.3 mm and a depth of 0.07 mm to 0.13 mm.

9. Apparatus for coating a web (8), in particular a paper or board web, with pigmented colour, comprising two rolls (3, 4) which are mounted axially parallel beside each other in a frame, of which one roll (3) is mounted such that it can be pressed circumferentially against the other roll (4), and having at least one application and metering system (7, 8) for a roll (3, 4), which can be pressed against the circumferential surface of a roll (3, 4) outside the region of the press nip (5) formed between the rolls (3, 4), **characterized in that** the metering system (7, 8) contains a doctor rod (1) according to one of Claims 1 to 8 as a metering element.

10. Apparatus for coating a web, in particular a paper or board web, comprising a backing roll, around which the web is guided, comprising an applicator in the region of the backing roll around which the web wraps, and comprising a metering system which follows in the web running direction, **characterized in that** the metering system contains a doctor rod according to one of Claims 1 to 8 as a metering element.

## Revendications

1. Tige de raclage pour un dispositif d'enduction, comprenant un corps de base de forme cylindrique en acier, sur la surface d'enveloppe duquel est appliquée une couche de matière dure en chrome ou en céramique, **caractérisée en ce que** les fissures et les cratères dans la surface de la couche de matière dure sont fermés par un composé qui a été fabriqué dans un procédé d'implantation ionique par une réaction de la matière dure avec les ions appliqués dans un plasma.

2. Tige de raclage selon la revendication 1, **caractérisée en ce que** la surface de la matière dure a été traitée lors de la fabrication de la tige de raclage (1) avec un mélange d'ions qui contient des ions azote et/ou carbone, mais pas d'ions mono-métalliques.

3. Tige de raclage selon la revendication 1 ou 2, **caractérisée en ce que** le composé de recouvrement se compose de nitrure de chrome, de carbure de chrome et/ou de carbonitrure de chrome.

4. Tige de raclage selon l'une quelconque des revendications 1 à 3, **caractérisée en ce que** l'on applique en tant que couche de matière dure une couche de chrome de 20 µm à 60 µm, de préférence de 40 µm à 50 µm d'épaisseur.

5. Tige de raclage selon l'une quelconque des revendications 3 et 4, **caractérisée en ce que** la couche de chrome présente, après le traitement au plasma, une dureté de plus de 1200 HV, de préférence de 1400 HV à 1600 HV.

6. Tige de raclage selon l'une quelconque des revendications 1 à 5, **caractérisée en ce que** la surface d'enveloppe de la tige de raclage (1) présente sur sa périphérie des rainures continues.

7. Tige de raclage selon la revendication 6, **caractérisée en ce que** la surface en section transversale ouverte des rainures, obtenue par une coupe longitudinale centrale à travers la tige de raclage (1), est comprise entre 25 mm² et 150 mm² par mètre de longueur de tige de raclage.

8. Tige de raclage selon la revendication 6 ou 7, **caractérisée en ce que** les rainures périphériques présentent une largeur mesurée dans la direction de l'axe de la tige de raclage (1) de 0,1 mm à 0,3 mm et une profondeur de 0,07 mm à 0,13 mm.

9. Dispositif pour l'enduction d'une bande de matériau (8), en particulier une bande de papier ou de carton avec un colorant à pigments, comprenant deux cylindres (3, 4) montés dans un bâti l'un à côté de l'autre et avec leurs axes parallèles, dont un cylindre (3) est monté de manière à pouvoir être pressé avec sa périphérie contre l'autre cylindre (4), et
comprenant au moins un système d'enduction et de dosage (7, 8) pour un cylindre (3, 4), qui peut être placé en dehors de la région de la ligne de contact (5) formée entre les cylindres (3, 4) contre la surface d'enveloppe d'un cylindre (3, 4), **caractérisé en ce que** le système de dosage (7, 8) contient, en tant qu'élément de dosage, une tige de raclage (1) selon l'une des revendications 1 à 8.

10. Dispositif pour l'enduction d'une bande de matériau, en particulier une bande de papier ou de carton avec un cylindre conjugué, autour duquel est guidée la bande de matériau, avec un appareil d'enduction dans la région du cylindre conjugué entourée par la bande de matériau et avec un système de dosage subséquent dans la direction d'avance de la bande, **caractérisé en ce que** le système de dosage contient, en tant qu'élément de dosage, une tige de raclage selon l'une des revendications 1 à 8.
